# EUROPÄISCHE PATENTSCHRIFT

(11) **EP 3 417 356 B1**
(45) Veröffentlichungstag und Bekanntmachung des Hinweises auf die Patenterteilung: **15.04.2020**
(21) Anmeldenummer: 17704463.3
(22) Anmeldetag: 10.02.2017
(51) Int. Cl.: G06F 3/01, H03K 17/96, G06F 3/0488

(54) **KRAFTFAHRZEUG-BEDIENVORRICHTUNG MIT FEDERND GELAGERTEM BETÄTIGUNGSELEMENT UND BEDIENHAPTIK**
MOTOR-VEHICLE OPERATING DEVICE HAVING A RESILIENTLY MOUNTED ACTUATING ELEMENT AND OPERATING HAPTICS
DISPOSITIF DE COMMANDE D'UN VÉHICULE AUTOMOBILE AVEC ÉLÉMENT D'ACTIONNEMENT LOGÉ SUR RESSORT ET SYSTÈME HAPTIQUE DE COMMANDE

(30) Priorität: 20.02.2016 DE 102016002021
(43) Veröffentlichungstag der Anmeldung: 26.12.2018
(73) Patentinhaber: Audi AG, 85045 Ingolstadt (DE)
(72) Erfinder: WACHINGER, Michael, 86571 Winkelhausen (DE)
(86) Internationale Anmeldenummer: PCT/EP2017/052999
(87) Internationale Veröffentlichungsnummer: WO 2017/140586

(56) Entgegenhaltungen:
- WO-A1-2008/151863
- DE-A1- 10 312 338
- US-A1- 2013 257 817

## Beschreibung

Die Erfindung betrifft eine Bedienvorrichtung für ein Kraftfahrzeug. Durch die Bedienvorrichtung ist ein Betätigungselement bereitgestellt, das translatorisch auslenkbar in einem Gehäuse gehalten ist. Das Betätigungselement kann beispielsweise ein Touchscreen (Berührungsbildschirm) sein. Das Betätigungselement ist dabei federnd gelagert, wozu ein Federelement bereitgestellt ist, welches das Betätigungselement mit einer Rückstellkraft in Richtung zu einer Ruhestellung hin beaufschlagt. Zur Erfindung gehört auch ein Kraftfahrzeug mit der erfindungsgemäßen Bedienvorrichtung.

Eine Bedienvorrichtung der genannten Art ist beispielsweise aus der DE 103 12 338 A1 bekannt. Danach ist eine berührungsempfindliche Erfassungsvorrichtung in einem Gehäuse auf vier Federstreifen gelagert, von denen jeder domförmig gebogen ist und auf zwei Stützelementen gelagert ist. Die jeweilige domförmige Ausformung ist zwischen den beiden Stützelementen angeordnet und dient als Auflagepunkt für die Erfassungsvorrichtung. Bei einer solchen Anordnung ist es schwierig, einen Aktor zum Bereitstellen einer haptischen Rückmeldung an der Erfassungsvorrichtung anzuordnen, da hier diese an vier Stellen unabhängig gelagert ist und für eine wirkungsvolle haptische Rückmeldung der Aktor entsprechend an allen vier Auflagepunkten wirken können muss.

Eine solche vierfache Eintragung von haptischen Signalen ist beispielsweise der KR 2012 000 1302 A bekannt. Danach ist ein beweglich gelagertes Betätigungselement in Form einer Scheibe auf vier Vibrationslautsprecher gelagert, welche die Scheibe halten und bei Bedarf mit einer Vibration beaufschlagen. Nachteilig bei dieser Anordnung ist, dass eine federnde Lagerung der Scheibe nur begrenzt möglich ist, da hierzu die Vibrationslautsprecher baulich angepasst werden müssen.

Aus der DE 10 2006 021 593 A1 ist zum Erzeugen eines Vibrationssignals an einem Betätigungselement eine Aktoreinrichtung bekannt, die unmittelbar an dem Betätigungselement befestigt ist und aufgrund ihrer Massenträgheit eine Vibration in das Betätigungselement eintragen kann. Nachteilig bei dieser Lösung ist, dass durch das Anordnen der verhältnismäßig schweren Aktoreinrichtung an dem Betätigungselement dieses träge und daher nur mit einer entsprechend großen Betätigungskraft durch einen Benutzer betätigbar ist.

Der Erfindung liegt die Aufgabe zugrunde, eine Bedienvorrichtung mit einem translatorisch auslenkbaren Betätigungselement bereitzustellen, das federnd gelagert ist und einen zentralen Angriffspunkt zum Beaufschlagen des Betätigungselements mit einer Aktorkraft und/oder zum Erfassen einer auf das Betätigungselement wirkenden Betätigungskraft eines Nutzers bereitstellt.

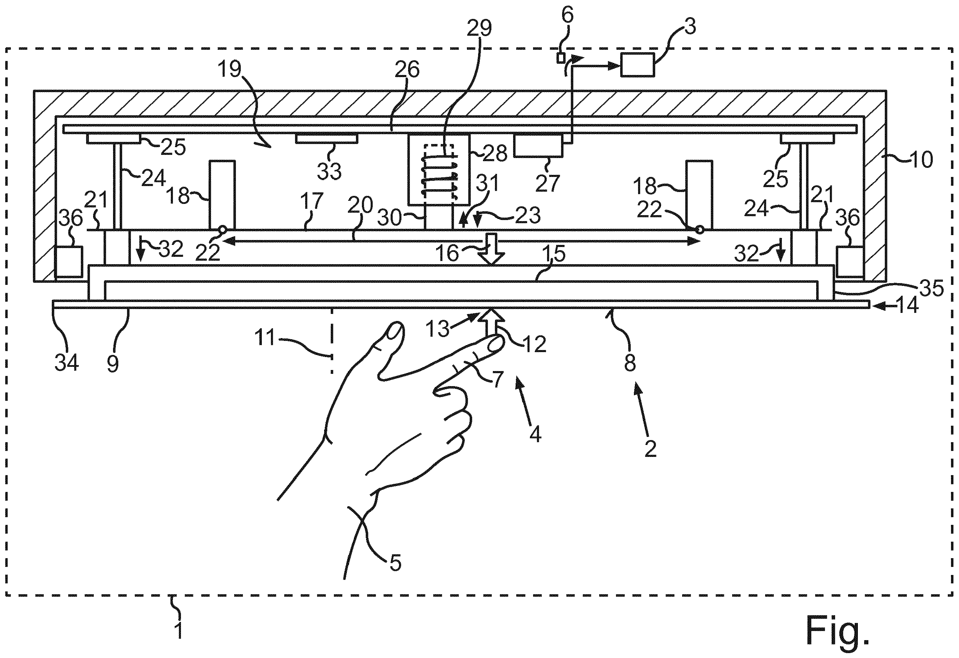

Die Aufgabe wird durch die Gegenstände der unabhängigen Patentansprüche gelöst. Vorteilhafte Weiterbildungen der Erfindung sind durch die Merkmale der abhängigen Patentansprüche, die folgende Beschreibung sowie die Figur offenbart.

Durch die Erfindung ist eine Bedienvorrichtung für ein Kraftfahrzeug bereitgestellt. In an sich bekannter Weise weist die Bedienvorrichtung ein Gehäuse zum Befestigen der Bedienvorrichtung in dem Kraftfahrzeug und ein Betätigungselement auf. Das Betätigungselement ist in dem Gehäuse derart gelagert, dass es durch Beaufschlagen mit einer Betätigungskraft translatorisch aus einer Ruhelage auslenkbar ist. Bei dem Betätigungselement kann es sich beispielsweise um eine Taste oder eine Tastenleiste oder auch um einen Touchscreen oder ein Touchpad (berührungssensitive Eingabefläche) handeln. Des Weiteren ist ein Federelement bereitgestellt, durch welches das Betätigungselement federnd gelagert ist und durch welches das Betätigungselement bei der besagten translatorischen Auslenkung aus der Ruhestellung mit einer Rückstellkraft in Richtung zur Ruhestellung hin beaufschlagt ist.

Um nun einen zentralen Angriffspunkt zum Bereitstellen einer Kraft für ein haptisches Feedback (Rückmeldung) oder zum Abgreifen oder Messen der auf das Betätigungselement wirkenden Betätigungskraft des Nutzers bereitzustellen, ist erfindungsgemäß vorgesehen, dass das Federelement als eine Platte oder ein Streifen ausgestaltet ist und durch zumindest zwei Lagerelemente bezüglich des Gehäuses an einer jeweiligen Lagerstelle unbeweglich gelagert ist. In der Bedienvorrichtung sind also zwei Lagerböcke bereitgestellt, die bewegungsfest mit dem Gehäuse verbunden sind. An diesen Lagerböcken ist das Federelement angeordnet, wobei der jeweilige Befestigungsbereich des Federelements an den Lagerböcken eine Lagerstelle darstellt. Da nun zwei Lagerelemente vorhanden sind und damit auch zwei Lagerstellen an dem Federelement, ist zwischen den Lagerstellen ein Zwischenbereich definiert. Das Betätigungselement liegt dabei an dem Federelement außerhalb des Zwischenbereichs an zwei gegenüberliegenden Enden des Federelements an.

Durch die Erfindung ergibt sich der Vorteil, dass in dem Zwischenbereich eine Verformung des Federelements mit einer entsprechenden Verformung der beiden gegenüberliegenden Enden des Federelements korreliert und damit in dem Zwischenbereich der besagte Angriffspunkt oder Abgriffspunkt vorhanden ist, über welchen die beiden gegenüberliegenden Enden des Federelements gleichzeitig beeinflussbar und beispielsweise mit einer Kraft beaufschlagbar sind, sodass auch das Betätigungselement über beide Enden beispielsweise mit dieser Kraft beaufschlagbar ist.

Zu der Erfindung gehören optionale Weiterbildungen, durch deren Merkmale sich zusätzliche Vorteile ergeben.

Gemäß einer Weiterbildung ist an den Lagerstellen jeweils ein ortsfester Drehbereich für eine elastische Krümmung des Federelements gebildet. Drückt der Benutzer mit der besagten Betätigungskraft auf das Betätigungselement, so wird diese Betätigungskraft an den Enden des Federelements auf dieses übertragen. Dabei krümmt sich das Federelement um die beiden Drehbereiche der Lagerelemente. Bei der sich ergebenden translatorischen Auslenkung ist dann der Zwischenbereich im Vergleich zur Ruhestellung des Betätigungselements diesem entgegengekrümmt. Mit anderen Worten findet durch die ortsfesten Drehbereiche in den Lagerstellen eine Richtungsumkehr der Auslenkung des Federelements statt. Diese kann in vorteilhafter Weise genutzt werden, um unidirektional wirkende Aktoren und/oder Sensoren im Zwischenbereich entgegengesetzt zu derjenigen Richtung bewegen zu können, in welche das Betätigungselement ausgelenkt ist.

Eine Weiterbildung sieht vor, dass an zumindest einem der gegenüberliegenden Enden des Federelements jeweils ein Stößelelement bereitgestellt ist, beispielsweise ein Stab oder eine Stange, über welches das jeweilige Ende bei der translatorischen Auslenkung des Betätigungselements auf einen Kraftsensor wirkt. Insbesondere ist das Stößelelement an einer dem Betätigungselement gegenüberliegenden Seite des Federelements angeordnet. Insbesondere sind das Stößelelement und ein Auflagebereich des Betätigungselements an dem Federelement ohne Versatz zueinander an dem Federelement angeordnet, sodass eine direkte Übertragung der Betätigungskraft in das Stößelelement erfolgt. Die Weiterbildung weist den Vorteil auf, dass mittels jedes Kraftsensors eine direkte Kraftmessung der Betätigungskraft ermöglicht ist.

Eine Weiterbildung sieht vor, dass in dem Zwischenbereich an einer dem Betätigungselement abgewandten Seite des Federelements eine Aktoreinrichtung bereitgestellt ist, welche mit dem Gehäuse verbunden ist und dazu eingerichtet ist, das Federelement im Zwischenbereich mit einer entlang einer Wirkachse der Betätigungskraft wirkenden Kraft zu beaufschlagen. Eine solche Aktoreinrichtung kann beispielsweise auf der Grundlage eines Piezoelements bereitgestellt sein. Die Aktoreinrichtung ist mit dem Federelement verbunden und erzeugt die Kraft also in dem Zwischenbereich an dem Federelement, welches die Kraft über ihre Enden auf das Betätigungselement überträgt. Durch diese Kopplung über das Federelement ist ein zeitlicher Verlauf der Kraft tiefpassgefiltert.

Wie bereits beschrieben, ist ein besonderer Vorteil der Anordnung im Zwischenbereich, dass eine Kraftumkehr über die Lagerelemente bewirkt wird. Gemäß einer Weiterbildung wird dies genutzt, indem die Aktoreinrichtung ausschließlich eine Zugkraft als die beschriebene Kraft erzeugt. Hierdurch ergibt sich der Vorteil, dass die Aktoreinrichtung technisch besonders einfach ausgestaltet sein kann.

So sieht eine Weiterbildung hierzu vor, dass die Aktoreinrichtung zum Bereitstellen der Zugkraft eine elektrische Spule zum Erzeugen einer magnetischen Anziehungskraft als die Zugkraft aufweist. Eine elektrische Spule als Bestandteil einer Aktoreinrichtung weist den Vorteil auf, dass mit technisch einfachen Mitteln eine verhältnismäßig große Zugkraft erzeugt werden kann, die aber eben nur unidirektional wirkt.

Eine Weiterbildung sieht vor, dass eine Steuereinrichtung bereitgestellt ist, welche dazu eingerichtet ist, während und/oder nach der translatorischen Auslenkung des Betätigungselements die Aktoreinrichtung durch ein Stellsignal derart anzusteuern, dass die Aktoreinrichtung über das Federelement das Betätigungselement mit einem der Betätigungskraft entgegenwirkenden haptischen Signal beaufschlagt und/oder eine Eigenschwingung des Betätigungselements um die Ruhestellung herum dämpft. Die Steuereinrichtung kann beispielsweise auf der Grundlage einer Prozessoreinrichtung, beispielsweise eines Mikrocontrollers oder eines Mikroprozessors, realisiert sein. Als das haptische Signal kann beispielsweise eine Vibration oder in vorteilhafter Weise und bevorzugt ein Gegenimpuls erzeugt werden. Insbesondere kann die Steuereinrichtung derart eingestellt sein, dass der Gegenimpuls bei Überschreiten eines Schwellenwerts der Betätigungskraft erzeugt wird, wobei die Betätigungskraft beispielsweise mittels des besagten zumindest einen Kraftsensors ermittelt werden kann. Über die beschriebene Anordnung kann mittels einer einzigen Aktoreinrichtung, beispielsweise einer einzigen elektrischen Spule, auch eine Eigenschwingung des Betätigungselements mit technisch einfachen Mitteln gedämpft oder verhindert werden. Hierzu kann die Aktoreinrichtung, insbesondere die elektrische Spule, mittels des Stellsignals eine Gegenbewegung entgegen der Eigenschwingung erzeugen oder auch beispielsweise einfach einen generatorischen Betrieb durch Kurzschließen von elektrischen Anschlüssen der Aktoreinrichtung aktivieren, sodass die Schwingungsbewegung der Eigenschwingung durch Umwandlung der Bewegungsenergie in Wärme gedämpft werden kann.

Eine Weiterbildung sieht vor, dass das Stellsignal als ein PWM-Signal (PWM - Pulsweitenmodulation) ausgestaltet ist. Hierdurch ergibt sich der Vorteil, dass mit einem einfachen Schaltelement, beispielsweise einem Transistor, mit nur zwei Schaltzuständen ein zeitlicher Verlauf eines Betrages der Kraft der Aktoreinrichtung eingestellt oder vorgegeben werden kann. Das Stellsignal kann alternativ dazu einen zeitlichen Verlauf gemäß einer Stufenfunktion mit zumindest einem konstanten Abschnitt zwischen einem Maximalwert und einem Minimalwert aufweisen. Durch eine Stufenfunktion kann das Betätigungselement stufenweise aus der translatorischen Auslenkung heraus zurück in die Ruhestellung geführt werden, sodass hierdurch eine Eigenschwingung des Betätigungselements vermieden wird.

Wie bereits ausgeführt, kann es sich bei dem Betätigungselement um einen Taster handeln. Bevorzugt ist vorgesehen, dass mittels des Betätigungselements mehrere unterschiedliche Funktionalitäten der Bedienvorrichtung aktiviert oder ausgewählt werden können. Hierzu sieht eine Weiterbildung vor, dass das Betätigungselement zum Bereitstellen einer Berührfläche eine Platte oder Scheibe, insbesondere eine Glasscheibe, aufweist und eine Sensoreinrichtung zum Unterscheiden zwischen mehreren unterschiedlichen Berührstellen an der Scheibe angeordnet ist. Ein solches Betätigungselement kann in der beschriebenen Weise als Touchscreen oder Touchpad bereitgestellt werden. Eine Weiterbildung sieht vor, dass das Betätigungselement als Schalterleiste ausgestaltet ist, welche mehrere unterschiedliche Tastbereiche aufweist. Jeder Tastbereich kann einen eigenen Näherungssensor zum Erfassen einer Berührung des Tastbereichs aufweisen.

Bisher war ausschließlich von einer translatorischen Auslenkung des Betätigungselements die Rede. Bevorzugt ist auch ausschließlich eine solche translatorische Bewegung des Betätigungselements aus der Ruhestellung zugelassen. Um dies sicherzustellen, sieht eine Weiterbildung vor, dass eine Führungseinrichtung bereitgestellt ist, durch welche eine Bewegung des Betätigungselements bezüglich des Gehäuses derart geführt ist, dass das Betätigungselement ausschließlich entlang einer Richtung der translatorischen Auslenkung bewegbar ist. Beispielsweise kann hierzu eine Schieneneinrichtung zum Führen des Betätigungselements vorgesehen sein. Diese Weiterbildung weist den Vorteil auf, dass das Betätigungselement nicht in dem Gehäuse verkantet, wenn es aus der Ruhestellung ausgelenkt wird. Dies ist insbesondere bei einer Scheibe in Form eines Touchscreens oder Touchpads mit entsprechend großer Berührfläche möglich.

Wie bereits ausgeführt, gehört zu der Erfindung auch ein Kraftfahrzeug, das eine Ausführungsform der erfindungsgemäßen Bedienvorrichtung aufweist. Mittels der Bedienvorrichtung kann in dem Kraftfahrzeug bevorzugt zumindest eine Fahrzeugkomponente bedienbar oder gekoppelt sein. Beispielsweise können als Fahrzeugkomponente ein Infotainmentsystem (Informations-Unterhaltungssystem) und/oder eine Klimatisierungseinrichtung und/oder eine Fahrzeugsitz-Verstelleinrichtung bedienbar sein.

Im Folgenden ist ein Ausführungsbeispiel der Erfindung beschrieben. Hierzu zeigt die einzige Figur (Fig.) eine schematische Darstellung einer Ausführungsform des erfindungsgemäßen Kraftfahrzeugs mit einer im Querschnitt dargestellten Ausführungsform der erfindungsgemäßen Bedienvorrichtung.

Bei dem im Folgenden erläuterten Ausführungsbeispiel handelt es sich um eine bevorzugte Ausführungsform der Erfindung. Bei dem Ausführungsbeispiel stellen die beschriebenen Komponenten der Ausführungsform jeweils einzelne, unabhängig voneinander zu betrachtende Merkmale der Erfindung dar, welche die Erfindung jeweils auch unabhängig voneinander weiterbilden und damit auch einzeln oder in einer anderen als der gezeigten Kombination als Bestandteil der Erfindung anzusehen sind. Des Weiteren ist die beschriebene Ausführungsform auch durch weitere der bereits beschriebenen Merkmale der Erfindung ergänzbar.

Die Figur zeigt ein Kraftfahrzeug 1, bei dem es sich beispielsweise um einen Kraftwagen, insbesondere einen Personenkraftwagen, handeln kann. Das Kraftfahrzeug 1 kann eine Bedienvorrichtung 2 aufweisen, die beispielsweise zum Bedienen zumindest einer Kraftfahrzeugkomponente 3 bereitgestellt sein kann. Die zumindest eine Kraftfahrzeugkomponente 3 kann beispielsweise ein Infotainmentsystem und/oder eine Klimatisierungseinrichtung und/oder eine Fahrzeugsitz-Verstelleinrichtung aufweisen.

Die Bedienvorrichtung 2 kann in Abhängigkeit von einer Berührbetätigung 4 eines Benutzers 5 ein Steuersignal 6 für die zumindest eine Fahrzeugkomponente 3 erzeugen. Die Berührbetätigung 4 kann der Benutzer 5 beispielsweise mit einem Finger 7 an einer berührungssensitiven Berührfläche 8 durchführen. Die Berührfläche 8 ist durch ein Betätigungselement 9 bereitgestellt, das in einem Gehäuse 10 der Bedienvorrichtung 2 entlang einer Auslenkachse oder Wirkachse 11 auslenkbar gelagert ist. Durch Beaufschlagen der Berührfläche 8 mit einer Betätigungskraft 12 an einer Berührstelle 13 der Berührfläche 8 wird das Betätigungselement 9 bei der Berührbetätigung 4 aus einer in der Figur dargestellten Ruhestellung 14 heraus bewegt. Durch eine Sensoreinrichtung 15 können hierbei beispielsweise Koordinaten der Berührstelle 13 an der Berührfläche 8 ermittelt und signalisiert werden.

Bei der Auslenkung des Betätigungselements 9 aus der Ruhestellung 14 wirkt eine Rückstellkraft 16 in Richtung zur Ruhestellung 14 hin auf das Betätigungselement 9. Diese Rückstellkraft 16 kann durch ein Federelement 17 erzeugt sein, das als Scheibe oder Streifen, das heißt als Federstreifen, ausgestaltet sein kann. Beispielsweise kann es sich um einen Stahlstreifen handeln, der z.B. als Stanzteil gefertigt sein kann. Das Federelement 17 kann in dem Gehäuse 10 an zwei Lagerelementen 18 angeordnet sein, welche fest mit einer Gehäusewandung 19 des Gehäuses 10 verbunden sein können. Das Betätigungselement 9 ist hierbei außerhalb eines Zwischenbereichs 20, der zwischen den Lagerelementen 18 definiert ist, an einem jeweiligen Ende 21 des Federelements 17 an dem Federelement 17 befestigt. Beim Auslenken des Betätigungselements 9 aus der Ruhestellung 14 krümmt sich das Federelement 17 um Drehpunkte 22, die auch die Grenzen für den Zwischenbereich 20 an den Lagerelementen 18 bilden können. Während hierdurch die Enden 21 entlang der Wirkachse 11 in dieselbe Richtung wie das Betätigungselement 9 ausgelenkt werden, führt der Zwischenbereich 20 beim Krümmen eine Gegenbewegung in eine Gegenrichtung 23 hin zum Betätigungselement 9 aus.

An den Enden 21 können Stößel 24 angeordnet sein, welche die Betätigungskraft 12 zumindest teilweise auf Kraftsensoren 25 übertragen können. Die Kraft wird mittels der Stößelelemente 24 und der Kraftsensoren 25 bevorzugt an gegenüberliegenden Enden des Betätigungselements 9 erfasst. Die Kraftsensoren 25 können an einer fest im Gehäuse 10 angeordneten Schaltungsplatine oder Leiterplatte 26 angeordnet sein. Durch die Schaltungsplatine 26 können die Kraftsensoren 25 mit einer Steuereinrichtung 27 verschaltet sein, durch welche in Abhängigkeit von einer mittels der Kraftsensoren 25 erfassten Kraft das Steuersignal 6 für die Kraftfahrzeugkomponenten 3 erzeugt werden kann. Hierbei kann vorgesehen sein, dass das Steuersignal 6 erzeugt wird, sobald die erfasste Kraft einen Schwellenwert überschreitet.

Um beim Erzeugen des Steuersignals 6 dem Benutzer 5 an der Berührfläche 8 ein haptisches Feedback zu geben, kann eine Aktoreinrichtung 28 bereitgestellt sein, die beispielsweise aus einem Piezoelement oder aus einer Anordnung einer elektrischen Spule 29 und einem darin angeordneten magnetischen Ankerelement 30 gebildet sein kann. Durch Bestromen der Spule 29 wird das Ankerelement 30 entgegen der Gegenrichtung 23 in die Aktoreinrichtung 28 hineingezogen. Über die Drehpunkte 22 wirkt dabei das Federelement 17 als ein elastischer Hebel, der auf beide Enden 21 wirkt, sodass die von der Aktoreinrichtung 28 erzeugte Kraft 31 als haptische Rückmeldung 32 beispielsweise in Form eines Stoßes oder eines Gegenimpulses entgegen der Betätigungskraft 12 auf den Finger 7 wirken kann.

Eine akustische Rückmeldung kann durch die Steuereinrichtung 27 mittels eines Lautsprechers 33 ebenfalls erzeugt werden. Insgesamt ergibt sich somit beim Betätigen des Betätigungselements 9 ein Effekt, als handele es sich um eine mechanische Taste, die beim Betätigen klickt. Dabei kann aber das Betätigungselement 9 beispielsweise als Touchscreen oder Touchpad oder Schalterleiste mit mehreren Schaltern ausgestaltet sein. Beispielsweise kann das Betätigungselement eine Scheibe 34 umfassen, die an einem Trägerkörper 35 zur Stabilisierung angeordnet sein kann. Um den Trägerkörper 35 mit besonders geringer Trägermasse auszugestalten, kann dieser einer Wabenstruktur oder Wabenform aufweisen.

Somit kann also durch die Bedienvorrichtung 1 ein Touchscreen mit Haptik bereitgestellt werden. Durch eine Führungseinrichtung 36 kann dafür gesorgt werden, dass nur ein Freiheitsgrad in der Bewegung entlang der Wirkachse 11 vorhanden ist, sodass die Betätigungsrichtung und die Wirkung der Aktoreinrichtung 28 auf derselben Wirkachse 11 liegen.

Über einen Federstreifen in Form des Federelements 17, der auf zwei Lagerböcken in Form der Lagerelemente 18 montiert ist, wird die Betätigungskraft 12 über die Stößelelementen 24 auf die Kraftsensoren 25 übertragen. Bei Überschreiten eines eingestellten Schwellenwerts für die Betätigungskraft können die Aktoreinrichtung 28 und der Lautsprecher 30 ausgelöst werden. Die Aktoreinrichtung 28 wirkt dabei bevorzugt mittig auf das Federelement 17. Dadurch wirkt die Aktoreinrichtung 28 gegenläufig zur Betätigungsrichtung der Betätigungskraft 12, aber auf derselben Wirkachse 11.

Insgesamt zeigt somit das Beispiel, wie durch die Erfindung ein Aufbau eines Touchscreens mit Haptik und Akustik bereitgestellt werden kann.

## Patentansprüche

1. Bedienvorrichtung (2) zum Verwenden in einem Kraftfahrzeug (1), aufweisend:
- ein Gehäuse (10) zum Befestigen der Bedienvorrichtung (2),
- ein bezüglich des Gehäuses (10) durch Beaufschlagen mit einer Betätigungskraft (12) translatorisch aus einer Ruhestellung (14) auslenkbar gelagertes Betätigungselement (9),
- ein Federelement (17), durch welches das Betätigungselement (9) federnd gelagert und bei der translatorischen Auslenkung mit einer Rückstellkraft (16) in Richtung zu einer Ruhestellung (14) hin beaufschlagt ist,
**dadurch gekennzeichnet, dass**
das Federelement (17) als eine Platte oder ein Streifen ausgestaltet ist und durch zumindest zwei Lagerelemente (18) bezüglich des Gehäuses (10) an einer jeweiligen Lagerstelle (22) unbeweglich gelagert ist, wobei zwischen den Lagerstellen (22) ein Zwischenbereich (20) definiert ist und das Betätigungselement (9) an zwei gegenüberliegenden Enden (21) des Federelements (17) außerhalb des Zwischenbereichs (20) an dem Federelement (17) anliegt.

2. Bedienvorrichtung (2) nach Anspruch 1, wobei an den Lagerstellen (22) jeweils ein ortsfester Drehbereich für eine elastische Krümmung des Federelements (17) gebildet ist, durch welche der Zwischenbereich (20) bei der translatorischen Auslenkung des Betätigungselements (9) im Vergleich zur Ruhestellung (14) des Betätigungselements (9) diesem entgegen gekrümmt ist.

3. Bedienvorrichtung (2) nach einem der vorhergehenden Ansprüche, wobei an zumindest einem der gegenüberliegenden Enden (21) des Federelements (17) jeweils ein Stößelelement (24) bereitgestellt ist, über welches das jeweilige Ende (21) bei der translatorischen Auslenkung auf einen Kraftsensor (25) wirkt.

4. Bedienvorrichtung (2) nach einem der vorhergehenden Ansprüche, wobei in dem Zwischenbereich (20) an einer dem Betätigungselement (9) abgewandten Seite des Federelements (17) eine Aktoreinrichtung (28) bereitgestellt ist, welche mit dem Gehäuse (10) verbunden ist und dazu eingerichtet ist, das Federelement (17) im Zwischenbereich (20) mit einer entlang einer Wirkachse (11) der Betätigungskraft (12) wirkenden Kraft (31) zu beaufschlagen.

5. Bedienvorrichtung (2) nach Anspruch 4, wobei die Kraft (31) ausschließlich eine Zugkraft (31) ist.

6. Bedienvorrichtung (2) nach Anspruch 5, wobei die Aktoreinrichtung (28) zum Bereitstellen der Zugkraft (31) eine elektrische Spule (29) zum Erzeugen einer magnetischen Anziehungskraft aufweist.

7. Bedienvorrichtung (2) nach einem der Ansprüche 4 bis 6, wobei eine Steuereinrichtung (27) bereitgestellt ist, welche dazu eingerichtet ist, während und/oder nach der translatorischen Auslenkung des Betätigungselements (9) mittels eines Stellsignals die Aktoreinrichtung (28) derart anzusteuern, dass diese über das Federelement (17) das Betätigungselement (9) mit einem der Betätigungskraft (12) entgegen wirkenden haptischen Signal (32) beaufschlagt und/oder eine Eigenschwingung des Betätigungselements (9) um die Ruhestellung (14) herum dämpft.

8. Bedienvorrichtung (2) nach Anspruch 7, wobei das Stellsignal ein PWM-Signal ist oder einen zeitlichen Verlauf gemäß einer Stufenfunktion mit zumindest einem konstanten Abschnitt zwischen einem Minimalwert und einem Maximalwert aufweist.

9. Bedienvorrichtung (2) nach einem der vorhergehenden Ansprüche, wobei das Betätigungselement (9) zum Bereitstellen einer Berührfläche (8) zum Empfangen der Betätigungskraft (12) eine Scheibe (34) aufweist, die eine Sensoreinrichtung (15) zum Unterscheiden zwischen mehreren unterschiedlichen Berührstellen (13) an der Scheibe (9) aufweist.

10. Kraftfahrzeug (1) mit einer Bedienvorrichtung (2) nach einem der vorhergehenden Ansprüche.

## Claims

1. Operating device (2) for use in a motor vehicle (1), having:
- a housing (10) for fastening the operating device (2),
- an actuating element (9) mounted such that it can be deflected out of a rest position (14) in a translatory manner with respect to the housing (10) by application of an actuating force (12),
- a spring element (17) via which the actuating element (9) is resiliently mounted and subjected to a restoring force (16) in the direction of a rest position (14) when said actuating element is deflected in the translatory manner,
**characterised in that**
the spring element (17) is designed as a plate or strip and is mounted on a respective bearing point (22) in an immovable manner with respect to the housing (10) by means of at least two bearing elements (18), wherein an intermediate region (20) is defined between the bearing points (22) and the actuating element (9) rests against the spring element (17) at two opposite ends (21) of the spring element (17) outside the intermediate region (20).

2. Operating device (2) according to claim 1, wherein a stationary rotation region is formed at each of the bearing points (22) for elastic bending of the spring element (17), and the intermediate region (20) is bent counter to the actuating element (9) in comparison to the rest position (14) of the actuating element in response to the bending of the spring element when the actuating element (9) is deflected in the translatory manner.

3. Operating device (2) according to any of the preceding claims, wherein a plunger element (24) is provided at at least one of the opposite ends (21) of the spring element; (17), via which plunger element the respective end (21) acts on a force sensor (25) during the translatory deflection.

4. Operating device (2) according to any of the preceding claims, wherein an actuator device (28) is provided on a side of the spring element (17) facing away from the actuating element (9) in the intermediate region (20), the actuator device being connected to the housing (10) and configured to apply a force (31) to the spring element (17) in the intermediate region (20) which acts along an axis of action (11) of the actuating force (12).

5. Operating device (2) according to claim 4, wherein the force (31) is only a tensile force (31).

6. Operating device (2) according to claim 5, wherein, in order to provide a tensile force (31), the actuator device (28) has an electric coil (29) for generating a magnetic attraction force.

7. Operating device (2) according to any of claims 4 to 6, wherein a control device (27) is provided which is configured to drive the actuator device (28) by means of a control signal whilst and/or after the actuating element (9) is deflected in the translatory manner such that said actuator device supplies, via the spring element (17), a haptic signal (32) to the actuating element (9), the haptic signal counteracting the actuating force (12), and/or dampens a natural oscillation of the actuating element (9) around the rest position (14).

8. Operating device (2) according to claim 7, wherein the control signal is a PWM signal or has a time profile according to a step function having at least one constant section between a minimum value and a maximum value.

9. Operating device (2) according to any of the preceding claims, wherein the actuating element (9) has a panel (34) which provides a contact area (8) for receiving the actuating force (12), the panel having a sensor device (15) for distinguishing between a plurality of different contact points (13) on the panel (9).

10. Motor vehicle (1) having an operating device (2) according to any of the preceding claims.

## Revendications

1. Dispositif de commande (2) pour utilisation dans un véhicule automobile (1), comprenant :
- un boîtier (10) pour la fixation du dispositif de commande (2),
- un élément d'actionnement (9) logé de manière à pouvoir être dévié par translation depuis une position de repos (14) par rapport au boîtier (10) par l'application d'une force d'actionnement (12),
- un élément formant ressort (17), par lequel l'élément d'actionnement (9) est logé de manière élastique et est soumis, lors de la déviation par translation, à une force de rappel (16) en direction de la position de repos (14),
**caractérisé en ce que**
l'élément formant ressort (17) est conçu en tant que plaque ou bande et est logé, par au moins deux éléments de palier (18), de manière immobile par rapport au boîtier (10), à une position de palier (22) respective, une zone intermédiaire (20) étant définie entre les positions de palier (22) et l'élément d'actionnement (9) reposant sur l'élément formant ressort (17) par deux extrémités (21) opposées de l'élément formant ressort (17) hors de la zone intermédiaire (20).

2. Dispositif de commande (2) selon la revendication 1, dans lequel une plage de rotation fixe pour une courbure élastique de l'élément formant ressort (17) est formée à chacune des positions de palier (22), au moyen de laquelle la zone intermédiaire (20) est courbée vers l'élément d'actionnement (9) lors de la déviation par translation de celui-ci par rapport à la position de repos (14) de l'élément d'actionnement (9).

3. Dispositif de commande (2) selon l'une quelconque des revendications précédentes, dans lequel au moins un élément pousseur (24) est prévu sur au moins une des extrémités opposées (21) de l'élément formant ressort (17), par lequel l'extrémité respective (21) agit sur un capteur de force (25) lors de la dérivation par translation.

4. Dispositif de commande (2) selon l'une quelconque des revendications précédentes, dans lequel un dispositif d'actionnement (28) est prévu dans la zone intermédiaire (20) sur un côté de l'élément formant ressort (17) opposé à l'élément d'actionnement (9), qui est connecté au boîtier (10) et à cet effet est configuré pour agir sur l'élément formant ressort (17) dans la zone intermédiaire (20) avec une force (31) agissant le long d'un axe actif (11) de la force d'actionnement (12).

5. Dispositif de commande (2) selon la revendication 4, dans lequel la force (31) est exclusivement une force de traction (31).

6. Dispositif de commande (2) selon la revendication 5, dans lequel le dispositif d'actionnement (28) pour fournir la force de traction (31) a une bobine électrique (29) pour générer une force d'attraction magnétique.

7. Dispositif de commande (2) selon l'une quelconque des revendications 4 à 6, dans lequel est prévu un dispositif de commande (27) qui est configuré pour commander le dispositif d'actionnement (28) au moyen d'un signal d'actionnement pendant et/ou après la déviation par translation de l'élément d'actionnement (9) de telle sorte qu'il agisse sur l'élément d'actionnement (9) par l'intermédiaire de l'élément formant ressort (17) avec un signal haptique (32) s'opposant à la force d'actionnement (12) et/ou amortisse une oscillation propre de l'élément d'actionnement (9) autour de la position de repos (14).

8. Dispositif de commande (2) selon la revendication 7, dans lequel le signal de commande est un signal PWM ou présente une caractéristique temporelle selon une fonction de pas avec au moins une section constante entre une valeur minimale et une valeur maximale.

9. Dispositif de commande (2) selon l'une quelconque des revendications précédentes, dans lequel l'élément d'actionnement (9) pour fournir une surface de contact (8) pour recevoir la force d'actionnement (12) présente un disque (34) qui a un dispositif de capteur (15) pour distinguer entre une pluralité de points de contact différents (13) sur le disque (9).

10. Véhicule automobile (1) avec un dispositif de commande (2) selon l'une quelconque des revendications précédentes.
